Europäisches Patentamt

European Patent Office

Office européen des brevets

(11) Publication number: **0 261 935**
**A2**

## (12) EUROPEAN PATENT APPLICATION

(21) Application number: **87308384.4**

(22) Date of filing: **22.09.87**

(51) Int. Cl.⁴: **H 03 H 11/30**

(30) Priority: **26.09.86 CA 519140**

(43) Date of publication of application:
**30.03.88 Bulletin 88/13**

(84) Designated Contracting States: **DE FR GB NL SE**

(71) Applicant: **NORTHERN TELECOM LIMITED**
**600 de la Gauchetiere Street West**
**Montreal Quebec H3B 4N7 (CA)**

(72) Inventor: **McGirr, Andrew Edward**
**10 Cyrus Court**
**Nepean Ontario K2H 9C9 (CA)**

(74) Representative: **Crawford, Andrew Birkby et al**
**A.A. THORNTON & CO. Northumberland House 303-306**
**High Holborn**
**London WC1V 7LE (GB)**

(54) Electronically controlled matching circuit.

(57) An electronically controlled matching circuit (13) for coupling RF (radio frequency) energy between a loop antenna (10) and Rf circuitry (14, 43). The matching circuit comprises a varactor diode (CS) connected in series with the RF energy and a fixed capacitor (CP) shunting one end of the diode to ground. This provides good matching when the loop antenna is physically much smaller than one half wavelength.

FIG. 10

EP 0 261 935 A2

**Description**

## ELECTRONICALLY CONTROLLED MATCHING CIRCUIT

This invention relates generally to electronic circuits and more particularly to an electronic circuit for matching an antenna to an RF (radio frequency) circuit.

Background of the Invention

Advances in low power microelectronics have spawned a variety of hand held, battery powered, sophisticated, wireless communication devices ranging from televisions to telephones. For many of these pocket size marvels, the antenna has become the most cumbersome and troublesome component. The antennas are made small to be compatible with the packaging. Such antennas are severely influenced by changes in their immediate environment, and since they are designed to be hand held, this aggravates the design challenge. One traditional solution has been to allow the introduction of additional losses, thus reducing the antenna's environmental sensitivity at the expense of reduced efficiency. This directly impacts the transmitter power and the receiver noise figure. For full duplex single antenna applications, the achievable dynamic range is correspondingly reduced.

It is recognized that an arbitrarily small loop of perfect conductor in an ideal environment, can theoretically perform almost identically to an ideal half-wave dipole, over an infinitesimally small bandwidth. Of course, real communications use antennas in dynamic, non-ideal environments, information transfer requires bandwidth, and high frequency superconducting materials are scarce. Furthermore, half-wave dipoles are themselves low gain and not very useful for many applications. Fortunately, lack of directivity is typically not an issue in portable communications since a receiver rarely knows a source's location. Hence omnidirectionality is often preferred. This leaves ohmic loss, high Q, and environmental sensitivity as obstacles to using very electrically small antennas for portable communications.

The loop antenna has stimulated significant research activity, but currently it has found only limited acceptance. However, for portable, miniature, communication devices the loop holds many advantages. It doesn't depend on a ground plane and its impedance is less sensitive to environmental perturbations than its monopole or dipole counterpart. Additionally, it is readily matched to a resistive load using only capacitive components, which tend to be less lossy than inductors and easier to adjust and control.

Summary of the Invention

The present invention is directed to an electronically controlled matching circuit designed to couple RF (radio frequency) energy between an antenna and RF circuitry (i.e. transmitter or receiver) with improved efficiency when using an antenna that is physically smaller than $\lambda/2$ (where $\lambda$ is the wavelength in free space of the RF source).

The present invention allows a very electrically small antenna to look very similar to a much larger antenna in terms of overall performance. It also helps to enable the antenna to work relatively efficiently in a dynamic environment.

Stated in other terms, the present invention is an electrically controlled matching circuit for coupling RF (radio frequency) energy between a loop antenna and RF circuitry, the matching circuit characterized by: a varactor diode connected in series with the RF energy and a capacitor shunting the cathode end of the diode to ground.

Stated in still other terms the present invention is an electrically controlled matching circuit for coupling RF (radio frequency) energy between a loop antenna and RF circuitry, the matching circuit characterized by: a varactor diode connected in series with the RF energy and a capacitor shunting the cathode end of the diode to ground; and a control circuit for monitoring the magnitude of the RF energy and for producing and applying a control signal to the varactor diode for controlling the capacitance thereof.

Brief Description of the Drawings

The invention will now be described in more detail with reference to the accompanying drawings, wherein like parts in each of the several figures are identified by the same reference character, and wherein:

Figure 1 is a simplified equivalent circuit for a small loop antenna;

Figure 2 is a simplified schematic of a small loop antenna;

Figure 3 is a simplified schematic of a small loop antenna together with a matching circuit;

Figures 4 through 9 inclusive are graphs illustrating certain performance features;

Figure 10 is a simplified schematic depicting one hardware implementation of the invention applied to a receiver;

Figure 11 is similar to Figure 10 but depicts a microprocessor implementation;

Figure 12 is a simplified schematic of the detector and filter of Figure 10;

Figure 13 is a simplified schematic depicting one hardware implementation of the invention applied to the transmitter;

Figure 14 is similar to Figure 13 but depicts a microprocessor implementation; and

Figure 15 is a simplified schematic depicting the peak detector of Figure 13.

## Detailed Description

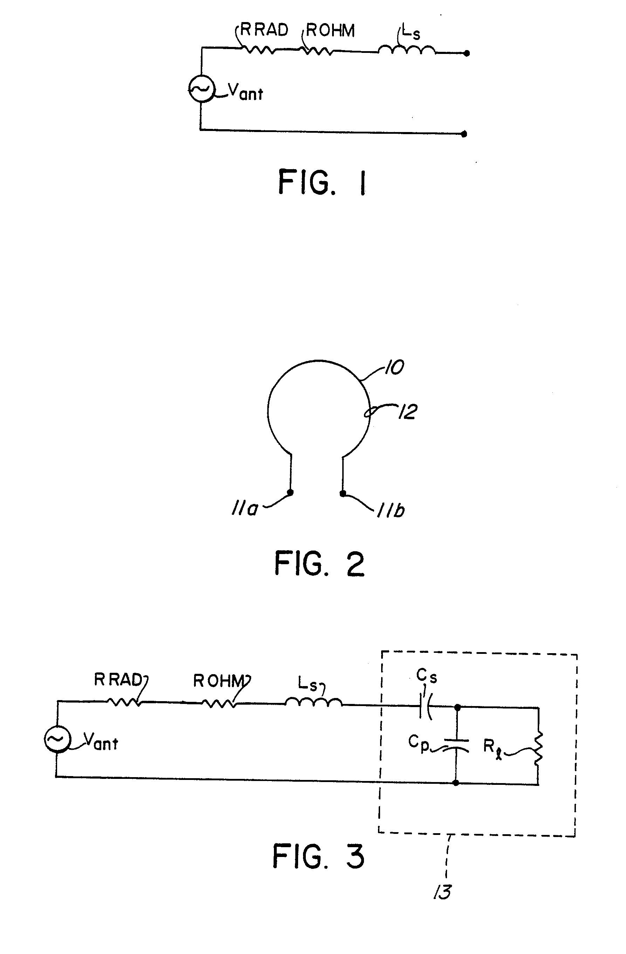

Figure 1 depicts the equivalent circuit for the electrically small loop antenna 10 of Figure 2. It consists of a voltage source, Vant, two resistors RRAD and ROHM, and an inductance $L_s$.

It will be assumed that the antenna is circular, made from round copper wire, and surrounded by air except for a small area of electronics forming a negligible perturbation at the antenna base. Changes in environment affecting the equivalent circuit parameters are considered later.

Loop antenna 10 of Figure 2 is comprised of a piece of copper wire 12 bent into the approximately circular shape as depicted in the figure, and having two terminals 11a and 11b (referred to collectively as terminals 11) for connection to associated equipment (not shown).

Note that:

$$Ls = r\mu \left[ \ln \frac{16r}{d} - 1.75 \right] H$$

$$RRAD = 320\pi^4 \left[ \frac{r}{\lambda} \right]^4 \Omega$$

$$ROHM = \frac{9.12r}{\sqrt{\lambda}\, d} \; m\Omega$$

where r = radius of loop
d = diameter of wire.

The quality factor, Qa, can be defined as:

$Qa = \frac{\omega Ls}{Ra}$ (where Ra = RRAD + ROHM)

As the thickness of wire 12 becomes significant in comparison to the loop dimensions, a parasitic capacitance will need to be added to the model. This is ignored here.

Examination of the preceding formulas will reveal that the resistance diminishes far more rapidly than the reactance as the loop becomes electrically smaller, and hence Qa can grow very large. A matching circuit using fixed passive components will therefore be very narrow bandwidth and accordingly quite sensitive to component tolerances and antenna parameters.

It is suggested here to use a two capacitor conjugate matching circuit 13 as illustrated in Figure 3. For many loops of practical interest, the values of Cs and Cp required are quite reasonable.

Normalized to the ideal (ROHM = 0) gain, the voltage transfer function (Vout/Vant) =

$$\frac{2\sqrt{RRAD/R\ell}}{1 + \frac{Ra}{R\ell} + \frac{Cp}{Cs} - \omega^2 LsCp + j\omega\left[ RaCp + \frac{Ls}{R\ell} - \frac{1}{\omega^2 CsR\ell} \right]}$$

This equation has been solved, without approximation, to yield a maximum power (and voltage) transfer from antenna to load (or vice versa) at a frequency ω, when,

$$Cp = \frac{1}{\omega_o R\ell \chi} \quad \text{and} \quad Cs = \frac{1}{\omega_o^2 Ls - \omega_o Ra\chi}$$

$$\text{where} \quad \chi = \sqrt{\frac{R\ell - Ra}{Ra}}$$

In the vicinity of resonance for reasonably high Q antennas (Qa > 10),

$$\left|\frac{Vout}{Vant}\right| = \frac{F}{\sqrt{1 + \frac{Qa^2(\kappa^2-1)}{4}}}$$

where $\kappa = \frac{\omega}{\omega_o} \approx 1$, F (fixed loss) $= \sqrt{\frac{RRAD}{Ra}}$

From above, the Q of the circuit is found to be approximately Qa/2 which is intuitively satisfying. The phase in the vicinity of reasonance is a sharp function of frequency

$$\frac{Vout}{Vant} = -\tan^{-1}\left[\frac{2x + Qa(\kappa^2-1)}{2.- xQa(\kappa^2-1)}\right]$$

At maximum power transfer $\kappa=1$, and

$$\frac{Vout}{Vant} \Rightarrow -\tan^{-1} x$$

As mentioned, an electrically small antenna used for portable communications, is subjected to rapid environment changes -from hand, to pocket, to metal desk top. These environmental fluctuations can greatly influence the antenna's equivalent circuit parameters rendering a narrow band matching circuit practically useless. In addition, Cp and Cs have some value tolerance as does the antenna's dimensions. Knowledge of sensitivities to Cp, RRAD, Ls, and Cs is therefore very important.

To Cp: Where the actual value of Cp is $\Psi$ times the predicted value,

$$\left|\frac{Vout}{Vant}\right| = \frac{2F/x}{\sqrt{\Psi^2 - 2\Psi + 1 + \frac{4}{x}}}$$

The 3 dB tolerance is $1 \pm \dfrac{2}{\sqrt{\dfrac{R\ell -1}{Ra}}}$

| for R$\ell$/Ra | 3 dB tolerance |
| --- | --- |
| 10 | ±67% |
| 100 | ±20% |
| 1000 | ±6.0% |

To R : Experiments have shown that Ra can vary by an order of magnitude due to hand effects. If the actual Ra is $\Psi$ times Ra expected then,

$$\left|\frac{Vout}{Vant}\right| = \frac{2F\sqrt{\Psi}}{1 + \Psi} \quad \text{and}$$

the 3 dB limits are $\dfrac{1}{(3+\sqrt{10})} < \Psi < (3+\sqrt{10})$

To Ls and Cs Hand effects and particularly, proximity to metal objects can cause significant variation in Ls. Add Cs's tolerance. Both inaccuracies will have an approximately equivalent effect; that of altering the circuit's optimum matching frequency. Again for the actual Ls or Cs $\Psi$ times predicted,

$$\left|\frac{V_{out}}{V_{ant}}\right| = \frac{F}{\sqrt{1 + \frac{Q_a^2}{4}(\Psi - 1)^2}}$$

giving a 3 dB tolerance of $1 \pm 2/Q_a$

| for $Q_a$ | 3 dB tolerance |
|-----------|----------------|
| 10        | $\pm 20\%$     |
| 100       | $\pm 2\%$      |
| 1000      | $\pm .2\%$     |

<u>Conclusion</u> Clearly for very high Q antennas, serious performance degradation will result from fluctuations in Cs, Ls and, to a lesser extent, Cp. The circuit is shown to be relatively tolerant to changes in Ra.

Using the above results it can be readily concluded that it is much more important to have control over Cs than Cp. Since it is very difficult to build a two loop control algorithm controlling both Cs and Cp, it is convenient to study the effects of just returning Cs. A complete model of the antenna was evolved using a circuit simulation package similar to Spice. Included are the variations of Vant, RRAD, and ROHM with frequency. For the simulations of automatic control, Cs was allowed to vary as:

$$Cs = \frac{Cp}{\omega^2 LsCp - 1}$$

which provides a good approximation to the optimum value.

<u>EXAMPLE LOOP ANTENNA DESIGN</u>
As an example, an antenna designed to operate at 200 MHz was chosen. Referring to the equations given previously let r = 5cm, d = 5 mm, and R$\ell$ = 50 ohms.
Ls = .209 micro-henries
RRAD = .380 ohms, and ROHM = .074 ohms
The ohmic loss can immediately be calculated as 20 log F = 0.77 dB. For the matching circuit,
Cp = 166 pF and Cs = 3.09 pF
Both values are practical at 200 MHz.

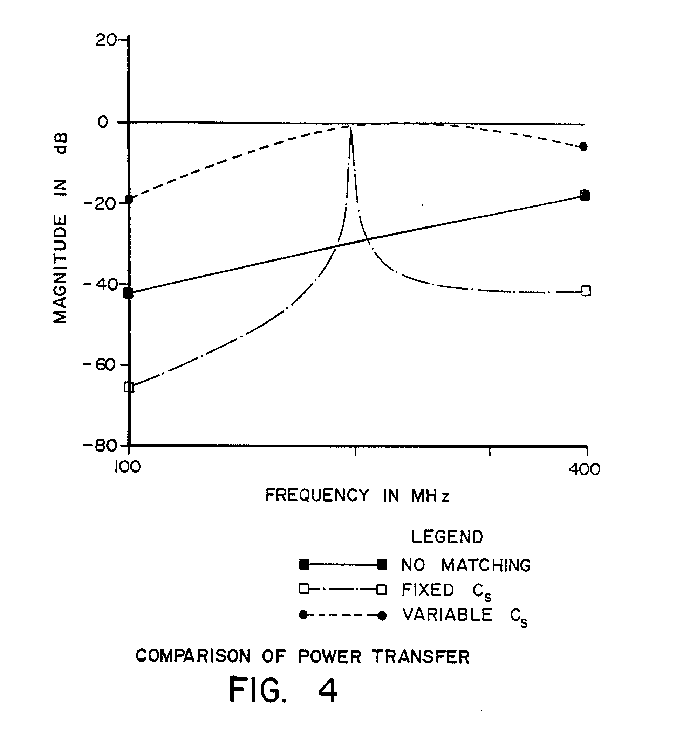

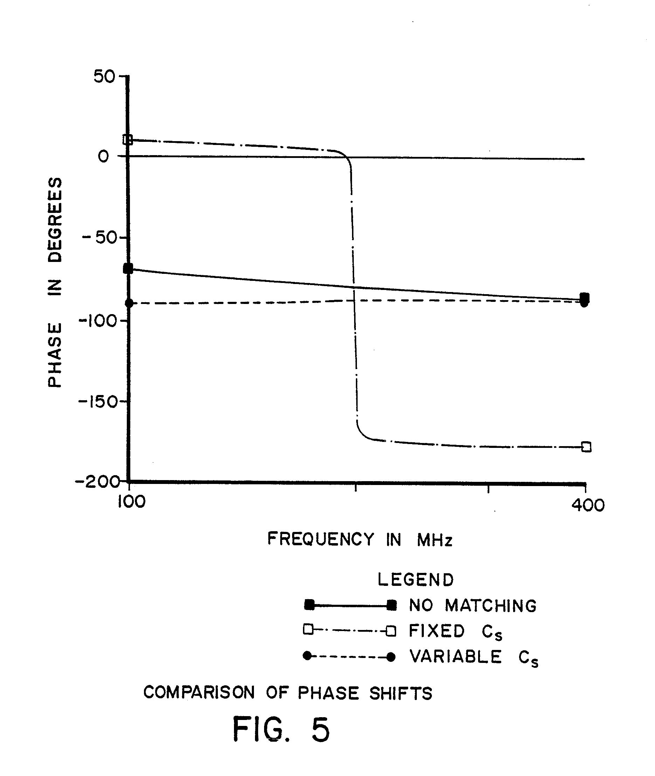

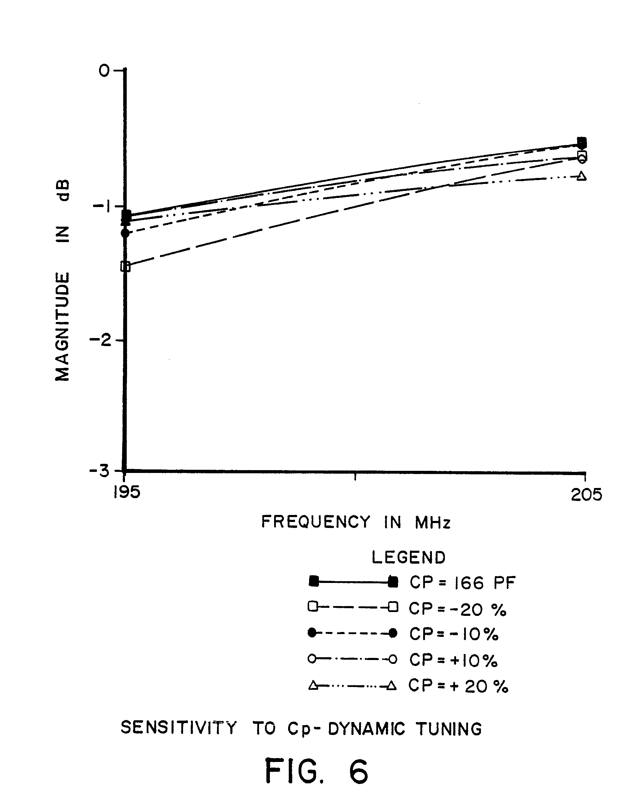

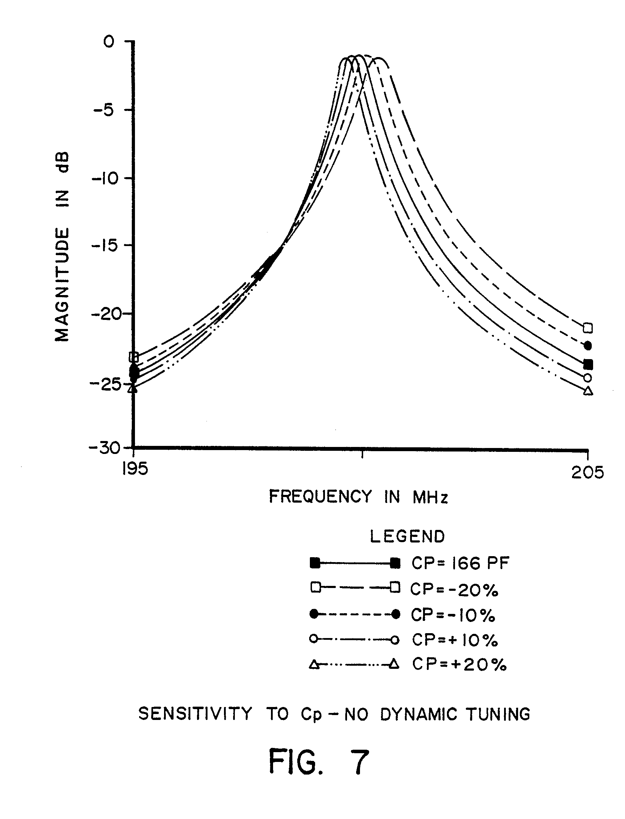

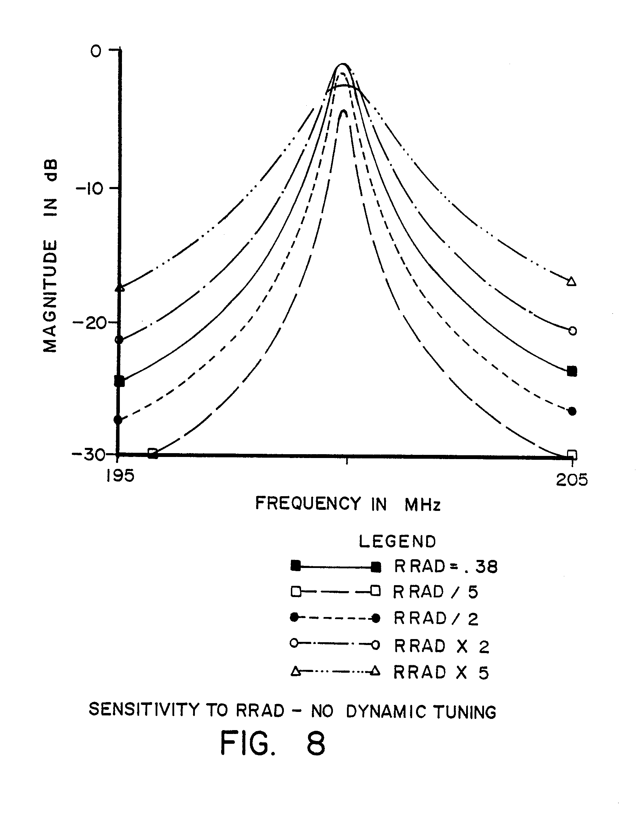

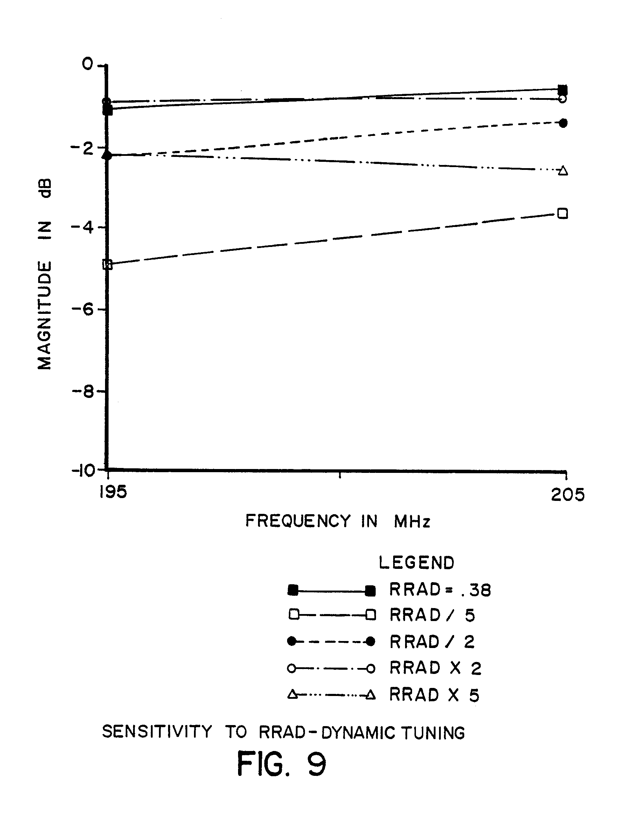

<u>ANTENNA RESPONSE</u>
The example antenna frequency response to an incident field, normalized to the ideal response at 200 MHz, is plotted for various parametric conditions in Figures 4 through 9. Graphs for Cs fixed correspond to sensitivities calculated above, and these are compared with Cs controlled. The improvement in bandwidth and hence tolerance to changes in Ls and Cs is quite good. Sensitivity to Cp is also significantly reduced. Although the sensitivity to R$a$ remains unchanged, it is not too serious to begin with.

<u>CONTROL TECHNIQUES</u>
Now that the advantages of tuning Cs have been presented, the logical question is, can it be practically implemented? Certainly a complete coverage of feedback techniques is beyond the scope of this document; but some potential methods are briefly discussed.

In the case of a receiver, a received field strength indication is used to determine the value of capacitor Cs, while in the case of a transmitter, the resonant condition is obtained by maximizing the voltage across capacitor Cp. "Dumb" feedback loops simply use hardware to move the value of Cs in a direction which increases the feedback signal, and oscillate back and forth when they reach a peak. These kind of loops can track quickly and accurately but require precision comparators and are susceptible to locking onto false peaks. "Smart" feedback loops, under processor control, can usually ensure they are tracking the true peak but require A/D's and D/A's and their tracking speed is limited by how fast the processor can make a comparison and update Cs.

The choice of methods will obviously depend on the required application.

Certain fundamental limitations of electrically small antennas - those of narrow bandwidth and acute sensitivity to their environment - can be mitigated in many applications with the addition of an electronically controlled, adaptive, matching circuit. This can dramatically increase the coupling efficiency of a small loop antenna over a wide bandwidth. The practicality of such an antenna is illustrated with an example of an r = λ/60 design at 200 MHz. A theoretical maximum efficiency of 84% is calculated. Simulations demonstrate a potential effective bandwidth of over 100 MHz using electronic compensation.

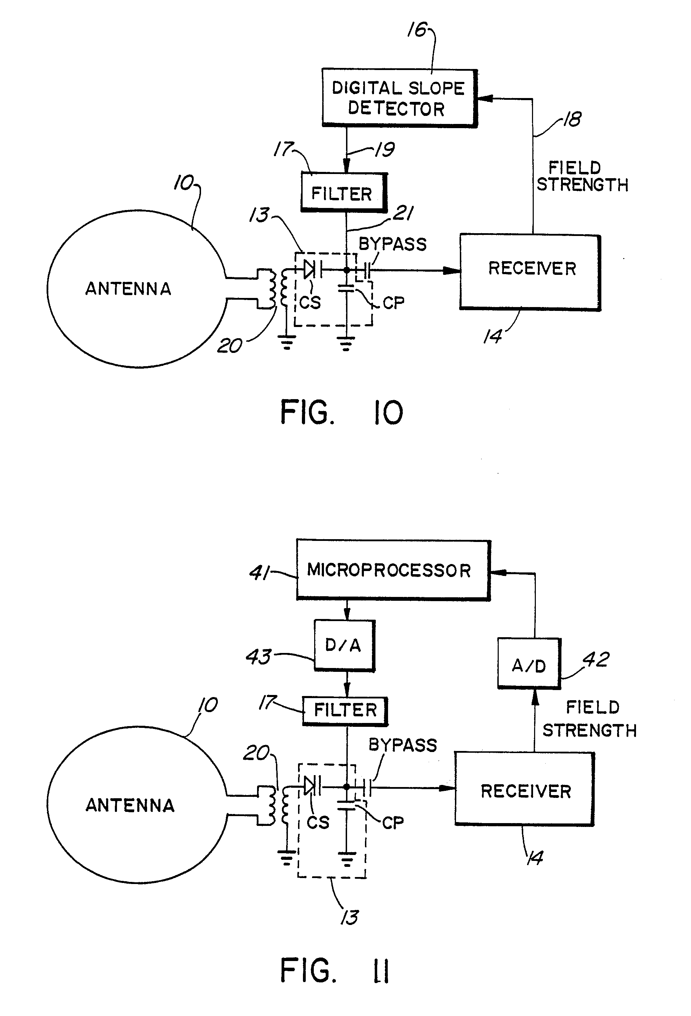

Figure 10 depicts the circuitry for such an implementation.

Antenna 10 is coupled to receiver 14 via matching circuit 13 and capacitor BYPASS. Matching circuit 13 is comprised of varactor diode CS (e.g. part No. MMBV105G by Motorola) and capacitor CP which has a value of approximately 166 picofarads. Note that varactor diode CS acts as an adjustable capacitance whose capacitance value varies according to the DC signal it receives from filter 17. The value of capacitor BYPASS is approximately 1000 picofarads.

The circuit of Figure 10 functions such that receiver 14 produces a field strength signal on lead 18, indicative of the received magnitude of the RF signal. The field strength is taken from a tap off a signetics NE604 (not shown), a chip that forms part of receiver 14.

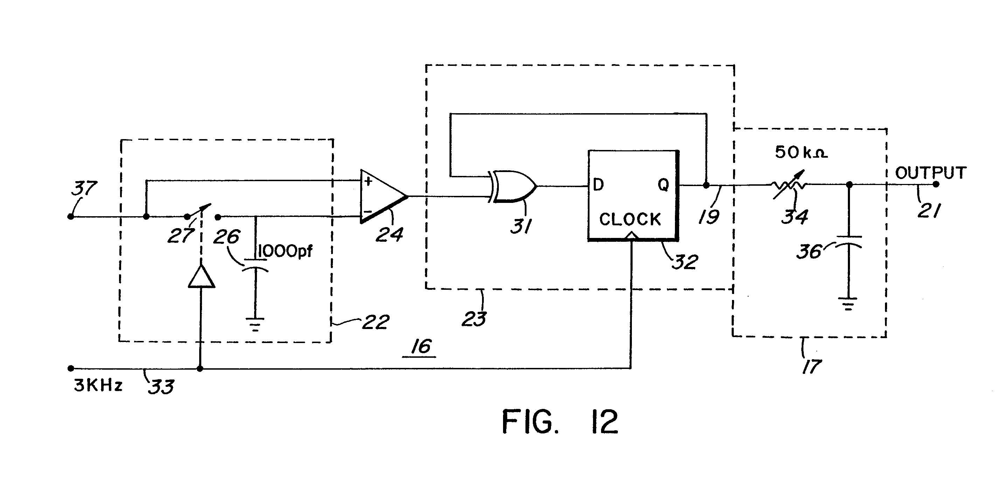

The field strength on lead 18 is applied to digital slope detector 16 (shown in more detail in Figure 12). The output of detector 16 is a DC control signal on lead 19. The control signal on lead 19 is applied to filter 17 which acts as an averaging or damping filter. The output of filter 17 is applied, by lead 21, to varactor diode CS for the purpose of controlling the capacitance value of diode CS and thus the impedance of matching circuit 13. The concept is to adjust the impedance of matching circuit 13 so as to increase the magnitude of the field strength on lead 18; this adjustment is performed by the feedback circuitry comprised of detector 16 and filter 17.

Figure 12 depicts digital slope detector 16 and filter 17 in more detail. Digital slope detector 16 is comprised of: a sample and hold circuit 22 comprised of capacitor 26 and switching circuit 27 (e.g. CD4066); comparator 24 (e.g. LM393); and increment/decrement circuit 23 comprised of exclusive-OR gate 31 (e.g. 74HC86), and D-type flip-flop 32 (e.g. 74HC74). Filter 17 comprises an adjustable resistor 34 (nominally 50K ohms) and capacitor 36. A 3 KHz clock signal is supplied by lead 33.

In simple terms, the circuit of Figure 12 operates as follows. A DC signal, indicative of the field strength of the received RF signal is applied to the input 37 of sample and hold circuit 22. Capacitor 26 "holds" the value of the signal sampled and applies it to one input of comparator 24. The other input of comparator 24 receives a subsequent field strength signal and the output of comparator 24 is indicative of the RF field strength increasing, decreasing or staying the same. The output of comparator 24 is applied to increment/decrement circuit 23 which toggles for a decreasing field strength signal and doesn't toggle for a increasing field strength signal. The output of circuit 23 is then applied to filter 17 which acts approximately like an integrator. The output of filter 17 is a DC control signal that is then applied to varactor diode CS.

Figure 11 depicts a similar arrangement to Figure 10 except that digital slope detector 16 is replaced by a suitably programmed microprocessor 41 and an analogue to digital converter 42 and a digital to analogue converter 43.

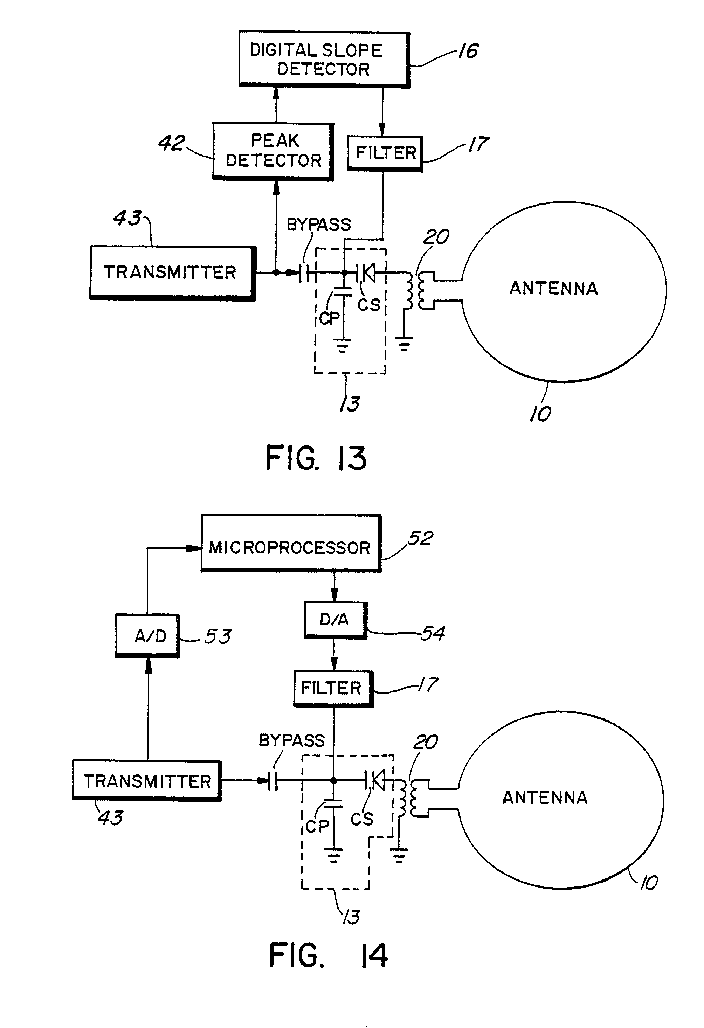

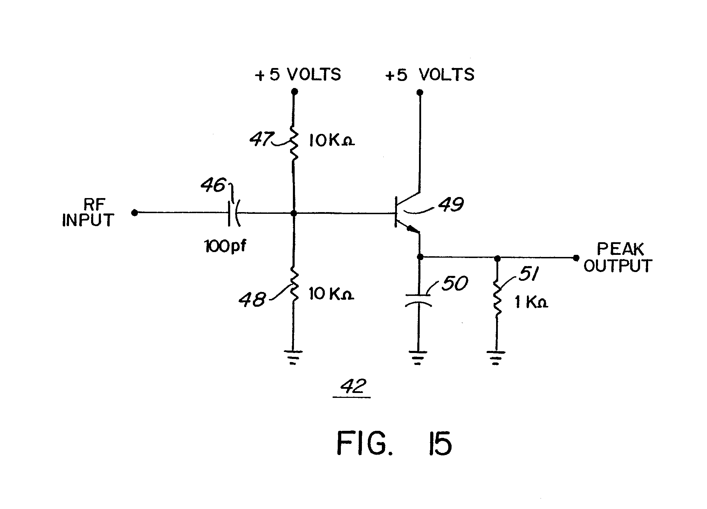

Figure 13 is similar to Figure 10 except that it is for a transmitter application. The principle behind the tuning of antenna 10 remains the same, as does matching circuit 13, digital slope detector 16, and filter 17. The difference between the two Figures is that Figure 13 additionally includes a peak detector 42, and has a transmitter 43 instead of a receiver. Peak detector 42, is shown in more detail in Figure 15 and comprises capacitor 46, resistors 47 and 48, transistor 49, capacitor 50, and resistor 51 connected as shown in Figure 15.

Figure 14 depicts a similar arrangement to Figure 13 except that peak detector 42 and digital slope detector 16 are replaced by a suitably programmed microprocessor 52, an analogue to digital converter 53, and a digital to analogue converter 54.

**Claims**

1. An electronically controlled matching circuit (13) for coupling RF (radio frequency) energy between a loop antenna (10) and RF circuitry (14,43), said matching circuit characterized by:
a varactor diode (CS) connected in series with the RF energy and a capacitor (CP) shunting the cathode end of said diode to ground.

2. The matching circuit of claim 1 wherein said RF circuitry is a receiver (14).

3. The matching circuit of claim 1 wherein said RF circuitry is a transmitter (43).

4. An electronically controlled matching circuit (13) for coupling RF (radio frequency) energy between a loop antenna (10) and RF circuitry (14,43), said matching circuit characterized by:
a varactor diode (CS) connected in series with the RF energy and a capacitor (CP) shunting the cathode end of said diode to ground; and
a control circuit (16, 17) for monitoring the magnitude (18) of said RF energy and for producing and applying a control signal to said varactor diode for controlling the capacitance thereof.

5. The matching circuit of claim 4 wherein said control circuit comprises a digital slope detector (16).

6. The matching circuit of claim 5 wherein said digital slope detector (16) is implemented with a microprocessor (41).

7. The matching circuit of claim 4 wherein said control circuit (16, 17) varies the magnitude of said control signal in a first direction and, in response to said RF energy increasing, continues to vary the magnitude of said control signal in said first direction; and in response to said RF energy decreasing, varies the magnitude of said control signal in the opposite direction.

8. The matching circuit of claim 4 wherein said control circuit (16, 17) comprises a sample and hold means (22) responsive to the magnitude of said RF energy; a comparator means (24) responsive to both the output of said sample and hold means and the magnitude of said RF energy; an increment/decrement means (23) responsive to the output of said comparator means; and an integrator means (17) responsive to the output of said increment/decrement means, the output of said increment/decrement means being said control signal.

9. An electronically controlled matching circuit (13) for coupling RF (radio frequency) energy between a loop antenna (10) and RF circuitry (14, 43), said matching circuit characterized by:

a varactor diode (CS) connected in series with the RF energy and a capacitor (CP) shunting the cathode end of said diode to ground;

a control circuit (16) for monitoring the magnitude of said RF energy and for producing and applying a control signal to said varactor diode for controlling the capacitance thereof;

said control circuit (16) comprising a sample and hold means (22) responsive to the magnitude of said RF energy; a comparator means (24) responsive to both the output of said sample and hold means and the magnitude of said RF energy; an increment/decrement means (23) responsive to the output of said comparator means; and an integrator means (17) responsive to the output of said increment/decrement means, the output of said increment/decrement means being said control signal;

wherein said control circuit (16) varies the magnitude of said control signal in a first direction and, in response to said RF energy increasing, continues to vary the magnitude of said control signal in said first direction; and in response to said RF energy decreasing, varies the magnitude of said control signal in the opposite direction.

0261935

FIG. 1

FIG. 2

FIG. 3

0261935

COMPARISON OF POWER TRANSFER

# FIG. 4

0261935

LEGEND

■━━━━■ NO MATCHING

□·—·—·□ FIXED $C_s$

●------● VARIABLE $C_s$

COMPARISON OF PHASE SHIFTS

FIG. 5

0261935

SENSITIVITY TO Cp- DYNAMIC TUNING

FIG. 6

0261935

SENSITIVITY TO Cp – NO DYNAMIC TUNING

## FIG. 7

0261935

FREQUENCY IN MHz

LEGEND

■————■ R RAD = .38

□— — —□ R RAD / 5

●-------● R RAD / 2

○—·—·—○ R RAD X 2

△—··—··△ R RAD X 5

SENSITIVITY TO RRAD - NO DYNAMIC TUNING

FIG. 8

0261935

SENSITIVITY TO RRAD-DYNAMIC TUNING

FIG. 9

0261935

FIG. 10

FIG. 11

FIG. 12

0261935

FIG. 13

FIG. 14

+5 VOLTS    +5 VOLTS

47 10KΩ

46 100pf

RF INPUT

49

48 10KΩ

50

51 1KΩ

PEAK OUTPUT

42

FIG. 15